# EUROPÄISCHE PATENTSCHRIFT

(11) **EP 3 345 467 B1**
(45) Veröffentlichungstag und Bekanntmachung des Hinweises auf die Patenterteilung: **30.12.2020**
(21) Anmeldenummer: 16805040.9
(22) Anmeldetag: 24.11.2016
(51) Int. Cl.: H05K 5/00, H05K 5/06, H05K 7/14, H05K 7/20, H05K 5/02

(54) **ELEKTRONISCHES GERÄT MIT KÜHLVORRICHTUNG UND EIN ZUGEHÖRIGES MONTAGEVERFAHREN**
ELECTRONIC DEVICE HAVING A COOLING APPARATUS, AND AN ASSOCIATED ASSEMBLY METHOD
APPAREIL ÉLECTRONIQUE MUNI D'UN DISPOSITIF DE REFROIDISSEMENT ET PROCÉDÉ DE MONTAGE AFFÉRENT

(30) Priorität: 01.12.2015 AT 510312015
(43) Veröffentlichungstag der Anmeldung: 11.07.2018
(73) Patentinhaber: MELECS EWS GmbH, 7011 Siegendorf (AT)
(72) Erfinder: GANAL, Emmanuel, 1140 Wien (AT); HELLINGER, Leopold, 3710 Ziersdorf (AT); NEUMANN, Gerhard, 3231 St. Margarethen (AT); NEUMANN, Philipp, 1200 Wien (AT)
(74) Vertreter: Maier, Daniel Oliver
(86) Internationale Anmeldenummer: PCT/EP2016/078661
(87) Internationale Veröffentlichungsnummer: WO 2017/093112

(56) Entgegenhaltungen:
- EP-A1- 2 561 733
- EP-A2- 2 429 273
- GB-A- 2 103 020
- US-A- 3 904 933
- US-A1- 2006 082 975

## Beschreibung

Die Erfindung bezieht sich auf ein elektronisches Gerät mit Kühlvorrichtung, insbesondere Steuergerät, welches in einem Gehäuse angeordnet ist und eine auf einer Trägerplatte angeordnete elektronische Schaltung umfasst.

Insbesondere in der Fahrzeugelektronik ergibt sich häufig die Notwendigkeit, elektronische Geräte in engem Bauraum zu integrieren und dabei elektrische Anschlüsse in Bezug auf ihre Ausrichtung variabel auszuführen.

Außerdem ist eine kompakte Anordnung elektrischer Anschlüsse in Bezug auf die Vorgaben bezüglich der Elektromagnetischen Verträglichkeit, z.B. nach der Europäischen Norm 61800-3, wichtig. Es besteht in diesem Zusammenhang oft die Forderung, auf Kabel, die aufwendige Maßnahmen der Schirmung benötigen, zu verzichten.

Weiterhin ist aufgrund hoher auftretender Betriebstemperaturen die Erzielung einer effektiven Wärmeleitung erforderlich.

Aus dem Stand der Technik ist die EP 2 429 273 A2 bekannt, in der eine Kühlvorrichtung für eine elektrisches Gerät und ein zugehöriges Herstellungsverfahren beschrieben ist. Das elektrische Gerät umfasst eine auf einer Trägerplatte angeordnete elektronische Schaltung und ist in einem Gehäuse angeordnet. Die Kühlvorrichtung besteht aus Kühlelementen, welche in dem Gehäuse angeordnet sind, die Trägerplatte und das Gehäuse mechanisch und thermisch kontaktieren und eine Wärmeableitung über das Gehäuse bewirken.

Der Nachteil dieser Anordnung ergibt sich aus der Eigenschaft, dass das Gehäuse zweiteilig ausgeführt ist und ein erster sowie ein zweiter Gehäuseteil über Schraubenverbindungen miteinander verbunden werden. Dadurch ergeben sich ein aufwendiger Montageprozess und eine große Zahl an Einzelteilen.

Weiterhin beschreibt die US 2006/0082975 A1 ein Gehäuse für eine elektronische Steuerung mit Kühlvorrichtungen und Kühlverfahren. Das Gehäuse weist eine Öffnung auf, die über ein Kopfteil verschlossen und abgedichtet ist. In dem Gehäuse ist eine Trägerplatte mit Transistoren angeordnet.
Die Transistoren werden mittels Federplatten bzw. Blattfedern gegen die Kühlvorrichtungen gepresst.

Ferner offenbart die US 3904933 A ein elektronisches Schaltmodul mit zu einem Stapel zusammengefassten Trägerplatten in einem thermisch leitfähigen Gehäuse. Die Trägerplatten weisen sägezahnförmige Seitenteile auf, welche ebenfalls sägezahnförmige Kühlkörper kontaktieren, wobei die Kühlkörper zwischen den Trägerplatten und dem Gehäuse angeordnet sind. Die Kühlkörper sind mittels Befestigungsschrauben mit einer Gehäuseplatte verschraubt.

Der Erfindung liegt die Aufgabe zugrunde, ein gegenüber dem Stand der Technik verbessertes elektronisches Gerät anzugeben.

Erfindungsgemäß wird diese Aufgabe gelöst mit einem elektronischen Gerät der eingangs genannten Art,
bei dem an einer Seite der Trägerplatte ein Federträger mit zumindest einer Kunststofffeder, welche die Trägerplatte mechanisch und thermisch kontaktiert, angeordnet ist,
bei dem Seitenflächen des Federträgers eine sägezahnförmige Kontur aufweisen,
bei dem an der, der Trägerplatte abgewandten Seite des Federträgers ein Federspanner mit Seitenflächen, die eine zu der sägezahnförmigen Kontur der Seitenflächen des Federträgers ein Pendant bildende sägezahnförmige Gegenkontur aufweisen, angeordnet ist, und
bei dem der Federspanner, wenn die Trägerplatte und der Federträger in das Gehäuse eingeführt sind, parallel zu einer Seitenfläche des Gehäuses weiter in das Gehäuse hinein schiebbar ist,

wobei die Trägerplatte, der Federträger und der Federspanner derart aufeinander und in dem Gehäuse angeordnet sind, dass die Trägerplatte, der Federträger und der Federspanner mittels der zumindest einen Kunststofffeder gegeneinander sowie gegen das Gehäuse verspannt sind.

Die Kunststofffeder ergibt den Vorteil eines Bauelements mit zwei Funktionen. Erstens ergibt die Kunststofffeder den thermischen Kontakt zwischen der Trägerplatte, dem Federträger, dem Federspanner und dem Gehäuse und bewirkt eine effektive Wärmeableitung über das Gehäuse, wodurch hohe Betriebstemperaturen erzielt werden können. Zweitens ergibt die durch die Kunststofffeder erzeugte Federkraft eine mechanische, kraftschlüssige Festhaltung der Anordnung aus der Trägerplatte, dem Federträger und dem Federspanner in dem Gehäuse. Es braucht nicht ein eigenes Bauelement für die thermische Kontaktierung und ein eigenes Bauelement für die mechanische Festhaltung eingesetzt werden.

Die sägezahnförmige Kontur des Federträgers und die sägezahnförmige Gegenkontur des Federspanners bewirken in vorteilhafter Weise einen kinematischen Zusammenhang zwischen dem Federträger und dem Federspanner, welcher eine zusätzliche, um 90° transformierte Bewegungsrichtung erzeugt und die Relativposition zwischen dem Federträger und dem Federspanner entsprechend verändert, wenn der auf dem Federträger angeordnete Federspanner in das Gehäuse eingeschoben wird. Diese Änderung der Relativposition zwischen dem Federträger und dem Federspanner bewirkt eine Kompression der Kunststofffeder.

Die zusätzliche, um 90° transformierte Bewegungsrichtung des Federspanners bewirkt, dass die Kompression der Kunststofffeder aus einer Richtung senkrecht zu einer Längsachse der Kunststofffeder, über eine senkrecht zu der Mantelfläche des Gehäuses angeordnete Gehäuseöffnung, ausgelöst werden kann.

Die Verspannung der Trägerplatte, des Federträgers und des Federspanners gegeneinander sowie gegenüber dem Gehäuse bewirkt, dass eine mechanische Festhaltung der Anordnung aus der Trägerplatte, dem Federträger und dem Federspanner in dem Gehäuse über die Anordnung aus der Trägerplatte, dem Federträger, dem Federspanner und dem Gehäuse selbst erfolgt, ohne dass dafür separate Verbindungselemente eingesetzt werden müssen.

Es ist günstig, wenn mit der Trägerplatte ein Stecker über abgewinkelte Kontaktierungselemente verbunden ist.
Diese Maßnahme bewirkt eine kompakte Anordnung eines elektrischen Anschlusses und es kann auf separate Verbindungselemente wie Kabel verzichtet werden. Die Eigenschaft abgewinkelter Kontaktierungselemente führt zu einer vorteilhaften Flexibilität in der Ausrichtung des Steckers, wodurch eine Anpassung an beschränkte Bauraumverhältnisse ermöglicht wird.

Eine vorteilhafte Ausgestaltung ergibt sich, wenn ein eine Lasche, einen Kontaktstift und eine Einzelleiterabdichtung umfassendes, über eine Bohrung in das Gehäuse geführtes Massekontaktelement derart angeordnet ist, dass der Kontaktstift einen auf der Bestückungsfläche der Trägerplatte angeordneten Federkontakt kontaktiert.
Durch diese Maßnahme ergibt sich eine günstige Anbindung einer Masse in der Weise, dass das Massekontaktelement die Funktionen eines Massekontakts, einer Dichtung und eines Befestigungselements (über die Lasche) in sich vereint. Über die Bohrung wird der Kontaktstift in der richtigen Position zu dem Federkontakt gehalten. Die Einzelleiterabdichtung dichtet die Bohrung ab.

Eine vorteilhafte Lösung erhält man, wenn eine auf dem Gehäuse angeordnete Montagekonsole an einer Unterseite eine Vertiefung in der Form der Lasche des Massekontaktelements aufweist, in welcher die Lasche angeordnet ist.
Durch diese Maßnahme wird einerseits die Lasche in der richtigen Position und Lage festgehalten und andererseits, über die Anordnung der Lasche auf der Unterseite der Montagekonsole, eine teilweise Ummantelung und somit ein Schutz des Massekontaktelements.

Günstig ist es, wenn das Massekontaktelement über die Lasche, auf welcher Montagezähne entlang einer Kreisbahn angeordnet sind, mit der Montagekonsole verstemmt ist.
Durch diese Maßnahme ergibt sich eine unmittelbare und daher vorteilhafte Verbindung zwischen dem Massekontaktelement und der Montagekonsole. Es wird eine kompakte Anordnung erzielt und auf separate Verbindungselemente kann verzichtet werden.

Eine vorteilhafte Lösung wird erzielt,
wenn der Federspanner auf dem Federträger derart angeordnet wird, dass sich zwischen der sägezahnförmigen Kontur des Federträgers und der sägezahnförmigen Gegenkontur des Federspanners eine Passung ergibt,
wenn die Trägerplatte parallel zu einer Grundfläche des Gehäuses über eine Gehäuseöffnung in das Gehäuse eingeführt wird, bis zwischen der Trägerplatte und einer Gehäuserückwand Kontakt besteht,
wenn der Federträger mit dem darauf angeordneten Federspanner parallel zu einer Seitenfläche des Gehäuses über die Gehäuseöffnung in das Gehäuse eingeführt wird, bis Kontakt zwischen dem Federträger und einer Gehäuserückwand besteht, und
wenn der Federspanner parallel zu einer Seitenfläche des Gehäuses weiter in das Gehäuse hinein geschoben wird, bis Kontakt zwischen dem Federspanner und einer Gehäuserückwand besteht.
Diese Maßnahme bewirkt eine Verspannung der Trägerplatte, des Federträgers und des Federspanners gegeneinander sowie gegen das Gehäuse. Es ist vorteilhaft, dass der Vorgang des Verspannens allein über ein Einschieben des Federspanners durchgeführt werden kann, ohne dass separate Hilfsmittel eingesetzt werden müssen. Dadurch vereinfacht sich der Montagevorgang.

Weiterhin sind alle Vorgänge dieser Maßnahme über eine senkrecht zu der Mantelfläche des Gehäuses angeordnete Gehäuseöffnung durchführbar, wodurch kein geteiltes Gehäuse eingesetzt werden muss und daher auf Verbindungselemente für die Verbindung von Gehäuseteilen verzichtet werden kann. Dadurch wird die Komplexität der Konstruktion über eine Verringerung der Teilezahl reduziert.

Nachfolgend wird die Erfindung anhand von Ausführungsbeispielen näher erläutert.

Es zeigen beispielhaft:

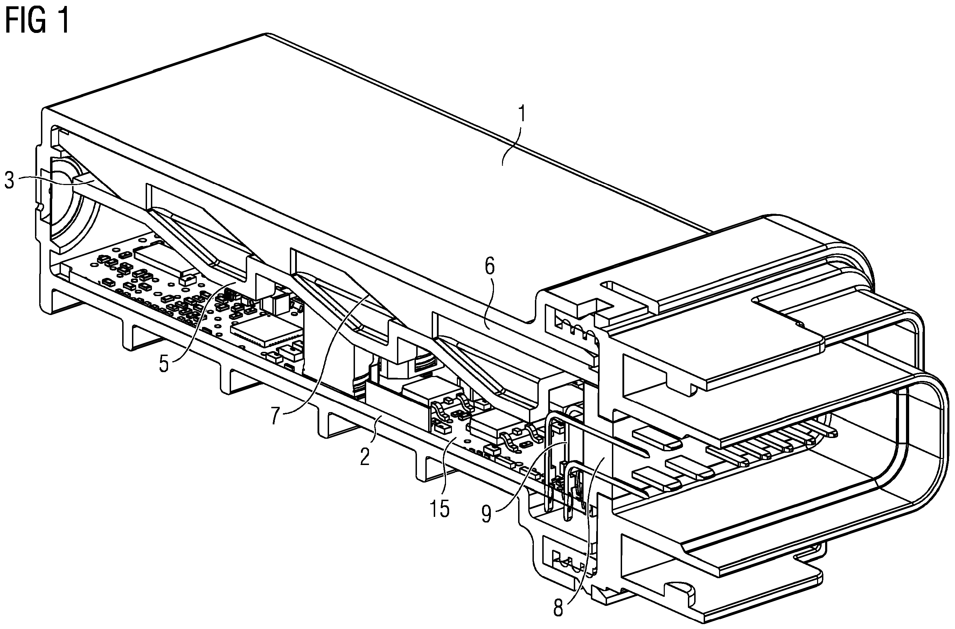

- Fig. 1:: Einen Schrägriss eines erfindungsgemäßen elektronischen Geräts in einer Schnittdarstellung, wobei ein Gehäuse, eine Trägerplatte, ein Federträger, ein Federspanner sowie ein Stecker dargestellt sind und die Vorderseite des elektronischen Geräts mit dem Stecker rechts unten in der Figur gezeigt wird,

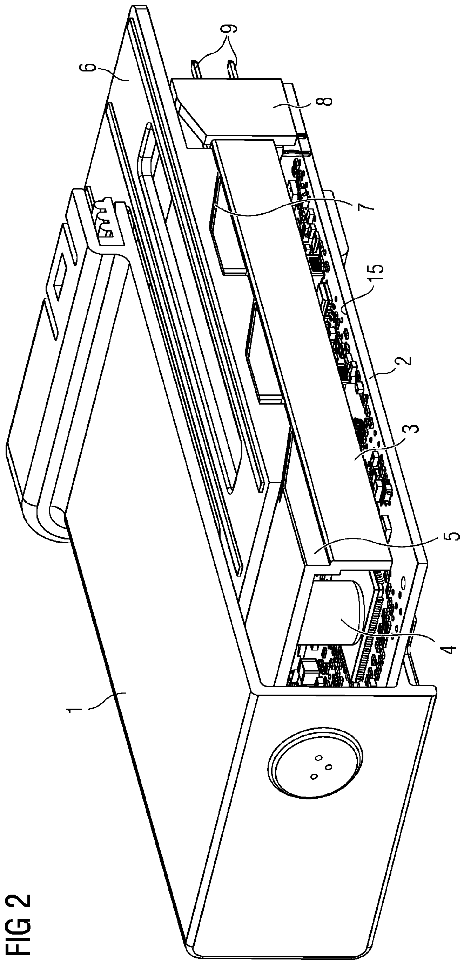

- Fig. 2:: Einen Schrägriss eines erfindungsgemäßen elektronischen Geräts in einer Schnittdarstellung, wobei ein Gehäuse, eine Trägerplatte, ein Federträger, ein Federspanner sowie ein Stecker dargestellt sind und die Rückseite des elektronischen Geräts links unten in der Figur gezeigt wird,

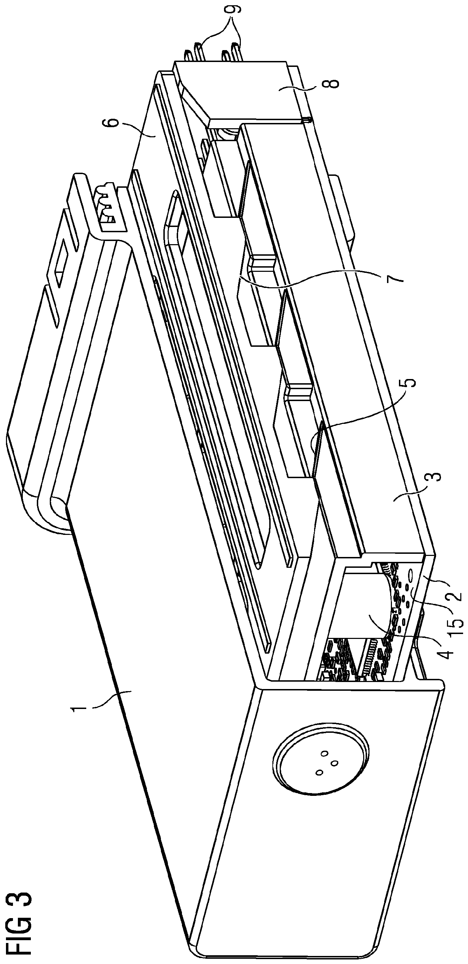

- Fig. 3:: Einen Schrägriss eines erfindungsgemäßen elektronischen Geräts in einer Schnittdarstellung, wobei ein Gehäuse, eine Trägerplatte, ein Federträger, ein Federspanner sowie ein Stecker dargestellt sind, die Rückseite des elektronischen Geräts links unten in der Figur gezeigt wird und die Anordnung des Federspanners von der Darstellung in Fig. 2 abweicht,

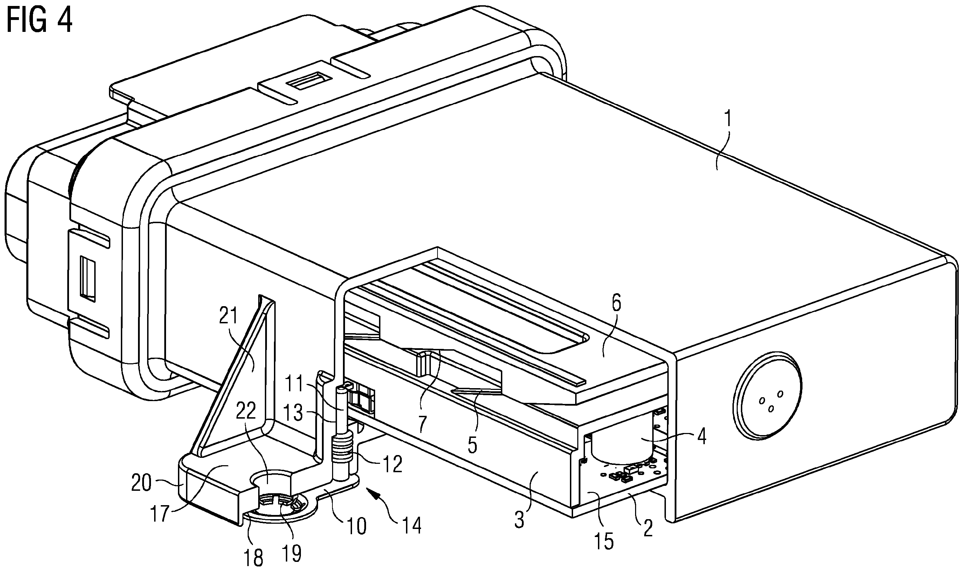

- Fig. 4:: Einen Schrägriss eines erfindungsgemäßen elektronischen Geräts in einer Schnittdarstellung, wobei ein Gehäuse, eine Trägerplatte, ein Federträger, ein Federspanner sowie eine Montagekonsole dargestellt sind und die Rückseite des elektronischen Geräts rechts unten in der Figur gezeigt wird, und

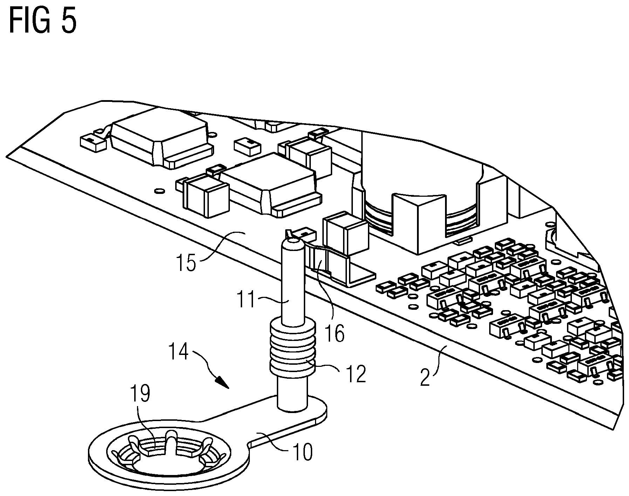

- Fig. 5:: Eine Detaildarstellung eines Massekontaktelements und einer Trägerplatte, wobei ein Kontaktstift einen auf der Trägerplatte angeordneten Federkontakt kontaktiert.

Fig. 1, Fig. 2, Fig. 3 und Fig. 4 zeigen eine beispielhafte Ausführungsvariante eines erfindungsgemäßen elektronischen Geräts, welches als Steuergerät ausgestaltet ist. Das elektronische Gerät weist eine Kühlvorrichtung auf, über die mittels zumindest einer, eine Bestückungsfläche 15 einer Trägerplatte 2 kontaktierenden Kunststofffeder 4 Wärme über einen Federträger 3, einen Federspanner 6 und ein Gehäuse 1 abgeführt wird.
Das Gehäuse 1 hat die Form eines Quaders mit abgerundeten Kanten.
Die Trägerplatte 2, der Federträger 3 und der Federspanner 6 sind in dem Gehäuse 1 derart angeordnet, dass die Bestückungsfläche 15 parallel zu einer der größeren Seitenflächen des Gehäuses 1 ausgerichtet ist.
Der Federträger 3 hat die Form einer Platte mit abgewinkelten Seitenteilen, die entlang der längsten Kante des Federträgers 3 verlaufen und im Bereich des Übergangs zwischen der Platte und den abgewinkelten Seitenteilen eine sägezahnförmige Kontur 5 aufweisen.
Auf dem Federträger 3 ist die Kunststofffeder 4 angeordnet. Die Kunststoffeder 4 ist zylindrisch ausgeführt und eine ihrer kreisförmigen Grundflächen ist parallel zu der Platte des Federträgers 3 ausgerichtet und mit der Platte des Federträgers verbunden. Die Kunststofffeder 4 ist auf jener Seite des Federträgers 3 angeordnet, auf der auch die abgewinkelten Seitenteile vorgesehen sind.
Der Federspanner 6 hat die Form einer Platte mit abgewinkelten Seitenteilen, die entlang der längsten Kante des Federspanners 6 verlaufen und an der, der Platte abgewandten Seite, eine sägezahnförmige Gegenkontur 7 aufweisen.
An einer der kürzeren Seiten der Trägerplatte 2 ist ein Stecker 8 angeordnet. Er weist in dieser beispielhaften Ausführungsvariante Kontaktierungselemente 9 auf, die um 90° abgewinkelt sind. Ein Ende eines Kontaktierungselements 9 kontaktiert die Bestückungsfläche 15 der Trägerplatte 2 und ist rechtwinklig zu dieser ausgerichtet. Ein anderes Ende des Kontaktierungselements 9 ist frei und verläuft in einer Ebene parallel zu der Bestückungsfläche 15.

Fig. 2 zeigt einen Montagezustand, in dem die Trägerplatte 2, der Federträger 3 und der Federspanner 6 in das Gehäuse 1 eingeschoben sind. Die Trägerplatte 2 liegt auf einer der größeren Seitenflächen des Gehäuses 1 auf und grenzt an eine Gehäuserückwand, welche senkrecht zu der Mantelfläche des quaderförmigen Gehäuses 1 ausgerichtet ist.
Der Federträger 3 ist parallel zu der Trägerplatte 2 derart angeordnet, dass die nicht mit dem Federträger 3 verbundenen Grundflächen der Kunststofffedern 4 die Bestückungsfläche 15 der Trägerplatte 2 kontaktieren. Der Federträger 3 grenzt an die Gehäuserückwand.
Der Federspanner 6 ist parallel zu dem Federträger 3 derart angeordnet, dass sich zwischen der sägezahnförmigen Gegenkontur 7 des Federspanners 6 und der sägezahnförmigen Kontur 5 des Federträgers 3 eine Passung ergibt.

Fig. 3 zeigt ebenfalls einen Montagezustand, in dem die Trägerplatte 2, der Federträger 3 und der Federspanner 6 in das Gehäuse 1 eingeschoben sind. Die Trägerplatte 2 liegt auf einer der größeren Seitenflächen des Gehäuses 1 auf und grenzt an eine Gehäuserückwand, welche senkrecht zu der Mantelfläche des quaderförmigen Gehäuses 1 ausgerichtet ist. Der Federträger 3 ist parallel zu der Trägerplatte 2 derart angeordnet, dass die nicht mit dem Federträger 3 verbundenen Grundflächen der Kunststofffedern 4 die Bestückungsfläche 15 der Trägerplatte 2 kontaktieren. Der Federträger 3 grenzt an die Gehäuserückwand.
Der Federspanner 6 ist, verglichen mit dem in Fig. 2 dargestellten Zustand, weiter in das Gehäuse 1 eingeschoben, so dass er an die Gehäuserückwand grenzt.
Zwischen der sägezahnförmigen Gegenkontur 7 des Federspanners 6 und der sägezahnförmigen Kontur 5 des Federträgers ergibt sich keine Passung. Die Erhebungen der sägezahnförmigen Kontur 5 kontaktieren die Erhebungen der sägezahnförmigen Gegenkontur 7.
Dadurch ergibt sich ein Kontakt des Federspanners 6 mit einer der größeren Seitenflächen des Gehäuses 1 und aufgrund dieses Kontakts eine Kompression der Kunststofffedern 4.
Dadurch sind die Trägerplatte 2, der Federträger 3 und der Federspanner 6 gegeneinander sowie gegen das Gehäuse 1 verspannt.

Fig. 4 zeigt eine mit dem Gehäuse 1 verbundene Montagekonsole 17 mit einer quaderförmigen Grundplatte 20, die in einer Ebene parallel zu einer der größeren Seitenflächen des Gehäuses 1 verläuft sowie mit zwei prismatischen Seitenteilen 21 mit dreieckigen Grundflächen, welche mit der Grundplatte 20 der Montagekonsole 17 sowie mit einer, an die Grundplatte 20 unmittelbar angrenzenden, kürzeren Seitenfläche des Gehäuses 1 verbunden sind. An einer, den Seitenteilen 21 abgewandten Seite der Grundplatte ist eine Vertiefung 18 ausgebildet, in der eine Lasche 10 eines Massekontaktelements 14 angeordnet ist. Die Lasche 10 des Montagekontaktelements 14 umfasst einen kreisringförmigen Bereich an dessen Innenkante Montagezähne 19 angeordnet sind. Die Montagezähne 19 sind im Bereich einer zylindrische Ausnehmung 22 mit der Grundplatte 20 der Montagekonsole 17 verstemmt.

Fig. 5 zeigt eine Detaildarstellung des Massekontaktelements 14. Senkrecht zu der Lasche 10 sind eine Einzelleiterabdichtung 12 sowie ein Kontaktstift 11 angeordnet und miteinander sowie mit der Lasche 10 verbunden. Die Einzelleiterabdichtung 12 und der Kontaktstift 11 sind über eine Bohrung 13 in dem Gehäuse 1, welche senkrecht zu den größeren Seitenflächen des Gehäuses verläuft, in das Gehäuse 1 geführt. Die Einzelleiterabdichtung 12 dichtet den Innenraum des Gehäuses 1 gegenüber der Umgebung ab.
Der Kontaktstift 11 kontaktiert einen Federkontakt 16, der an einer der längeren Seiten der Bestückungsfläche 15 der Trägerplatte 2 angeordnet ist.

### Liste der Bezeichnungen

- 1: Gehäuse
- 2: Trägerplatte
- 3: Federträger
- 4: Kunststofffeder
- 5: Sägezahnförmige Kontur
- 6: Federspanner
- 7: Sägezahnförmige Gegenkontur
- 8: Stecker
- 9: Kontaktierungselement
- 10: Lasche
- 11: Kontaktstift
- 12: Einzelleiterabdichtung
- 13: Bohrung
- 14: Massekontaktelement
- 15: Bestückungsfläche
- 16: Federkontakt
- 17: Montagekonsole
- 18: Vertiefung
- 19: Montagezahn
- 20: Grundplatte
- 21: Seitenteil
- 22: Ausnehmung

## Patentansprüche

1. Elektronisches Gerät mit Kühlvorrichtung, insbesondere Steuergerät, welches in einem Gehäuse (1) angeordnet ist und eine auf einer Trägerplatte (2) angeordnete elektronische Schaltung umfasst, **dadurch gekennzeichnet,**
**dass** an einer Seite der Trägerplatte (2) ein Federträger (3) mit zumindest einer Kunststofffeder (4), welche die Trägerplatte (2) mechanisch und thermisch kontaktiert, angeordnet ist,
**dass** Seitenflächen des Federträgers (3) eine sägezahnförmige Kontur (5) aufweisen,
**dass** an der, der Trägerplatte (2) abgewandten Seite des Federträgers (3) ein Federspanner (6) mit Seitenflächen, die eine zu der sägezahnförmigen Kontur (5) der Seitenflächen des Federträgers ein Pendant bildende sägezahnförmige Gegenkontur (7) aufweisen, angeordnet ist, und
**dass** der Federspanner (6), wenn die Trägerplatte (2) und der Federträger (3) in das Gehäuse (1) eingeführt sind, parallel zu einer Seitenfläche des Gehäuses (1) weiter in das Gehäuse (1) hinein schiebbar ist,
so dass die Trägerplatte (2), der Federträger (3) und der Federspanner (6) derart aufeinander und in dem Gehäuse angeordnet sind, dass die Trägerplatte (2), der Federträger (3) und der Federspanner (6) mittels der zumindest einen Kunststofffeder (4) gegeneinander sowie gegen das Gehäuse (1) verspannt sind.

2. Elektronisches Gerät nach Anspruch 1, **dadurch gekennzeichnet, dass** mit der Trägerplatte (2) ein Stecker (8) über abgewinkelte Kontaktierungselemente (9) verbunden ist.

3. Elektronisches Gerät nach Anspruch 1, **dadurch gekennzeichnet, dass** ein eine Lasche (10), einen Kontaktstift (11) und eine Einzelleiterabdichtung (12) umfassendes, über eine Bohrung (13) in das Gehäuse (1) geführtes Massekontaktelement (14) derart angeordnet ist, dass der Kontaktstift (11) einen auf der Bestückungsfläche (15) der Trägerplatte (2) angeordneten Federkontakt (16) kontaktiert.

4. Elektronisches Gerät nach Anspruch 3, **dadurch gekennzeichnet, dass** eine auf dem Gehäuse (1) angeordnete Montagekonsole (17) an einer Unterseite eine Vertiefung (18) in der Form der Lasche (10) des Massekontaktelements (14) aufweist, in welcher die Lasche (10) angeordnet ist.

5. Elektronisches Gerät nach Anspruch 4, **dadurch gekennzeichnet, dass** das Massekontaktelement (14) über die Lasche (10), auf welcher Montagezähne (19) entlang einer Kreisbahn angeordnet sind, mit der Montagekonsole (17) verstemmt ist.

6. Verfahren für die Montage eines elektronischen Geräts nach einem der Ansprüche 1, 2, 3, 4 oder 5, **dadurch gekennzeichnet,**
**dass** der Federspanner (6) auf dem Federträger (3) derart angeordnet wird, dass sich zwischen der sägezahnförmigen Kontur (5) des Federträgers (3) und der sägezahnförmigen Gegenkontur (7) des Federspanners eine Passung ergibt,
**dass** die Trägerplatte (2) parallel zu einer Seitenfläche des Gehäuses (1) über eine Gehäuseöffnung in das Gehäuse (1) eingeführt wird, bis zwischen der Trägerplatte (2) und einer Gehäuserückwand Kontakt besteht,
**dass** der Federträger (3) mit dem darauf angeordneten Federspanner (6) parallel zu einer Seitenfläche des Gehäuses (1) über eine Gehäuseöffnung in das Gehäuse (1) eingeführt wird, bis Kontakt zwischen dem Federträger (3) und einer Gehäuserückwand besteht, und
**dass** der Federspanner (6) parallel zu einer Seitenfläche des Gehäuses (1) weiter in das Gehäuse (1) hinein geschoben wird, bis Kontakt zwischen dem Federspanner (6) und einer Gehäuserückwand besteht.

## Claims

1. Electronic device comprising a cooling apparatus, in particular controller, which is arranged in a housing (1) and comprises an electronic circuit which is arranged on a carrier plate (2), **characterized**
**in that** a spring carrier (3) with at least one plastic spring (4) which makes mechanical and thermal contact with the carrier plate (2) is arranged on one side of the carrier plate (2),
**in that** side faces of the spring carrier (3) have a sawtooth-like contour (5),
**in that** a spring tensioner (6) with side faces, which have a sawtooth-like mating contour (7) which forms a pendant in relation to the sawtooth-like contour (5) of the side faces of the spring carrier, is arranged on that side of the spring carrier (3) which is averted from the carrier plate (2), and
**in that** the spring tensioner (6), when the carrier plate (2) and the spring carrier (3) are inserted into the housing (1), can be pushed further into the housing (1) parallel to a side face of the housing (1),
so that the carrier plate (2), the spring carrier (3) and the spring tensioner (6) are arranged one on the other and in the housing in such a way that the carrier plate (2), the spring carrier (3) and the spring tensioner (6) are braced against one another and against the housing (1) by means of the at least one plastic spring (4).

2. Electronic device according to Claim 1, **characterized in that** a plug (8) is connected to the carrier plate (2) by means of angled-away contact-making elements (9).

3. Electronic device according to Claim 1, **characterized in that** an earth contact element (14) which comprises a lug (10), a contact pin (11) and an individual conductor seal (12) and is guided into the housing (1) via a bore (13) is arranged in such a way that the contact pin (11) makes contact with a spring contact (16) which is arranged on the fitting surface (15) of the carrier plate (2).

4. Electronic device according to Claim 3, **characterized in that** a mounting bracket (17) which is arranged on the housing (1) has, on a bottom side, a recess (18) in the shape of the lug (10) of the earth contact element (14), in which recess the lug (10) is arranged.

5. Electronic device according to Claim 4, **characterized in that** the earth contact element (14) is caulked with the mounting bracket (17) by means of the lug (10) on which mounting teeth (19) are arranged along a circular path.

6. Method for mounting an electronic device according to one of Claims 1, 2, 3, 4 and 5, **characterized**
**in that** the spring tensioner (6) is arranged on the spring carrier (3) in such a way that a fit is produced between the sawtooth-like contour (5) of the spring carrier (3) and the sawtooth-like mating contour (7) of the spring tensioner,
**in that** the carrier plate (2) is introduced into the housing (1) parallel to a side face of the housing (1) via a housing opening until contact is established between the carrier plate (2) and a housing rear wall,
**in that** the spring carrier (3) with the spring tensioner (6) arranged on it is introduced into the housing (1) parallel to a side face of the housing (1) via a housing opening until contact is established between the spring carrier (3) and a housing rear wall, and
**in that** the spring tensioner (6) is pushed further into the housing (1) parallel to a side face of the housing (1) until contact is established between the spring tensioner (6) and a housing rear wall.

## Revendications

1. Appareil électronique muni d'un dispositif de refroidissement, et plus particulièrement appareil de commande qui est agencé dans un boîtier (1) et comprend un circuit électronique agencé sur une plaque de support (2), **caractérisé en ce que** :
sur un côté de la plaque de support (2) est agencé un support de ressort (3) avec au moins un ressort en plastique (4) qui est en contact mécanique et thermique avec la plaque de support (2),
des faces latérales du support de ressort (3) présentent un profil (5) en dents de scie,
sur le côté du support de ressort (3) opposé à la plaque de support (2) est agencé un compresseur de ressort (6) avec des faces latérales qui présentent un contre-profil (7) en dents de scie correspondant au profil (5) en dents de scie des faces latérales du support de ressort et
le compresseur de ressort (6) peut, lorsque la plaque de support (2) et le support de ressort (3) sont introduits dans le boîtier (1), être enfoncé plus avant dans le boîtier parallèlement à une face latérale du boîtier (1),
de sorte que la plaque de support (2), le support de ressort (3) et le compresseur de ressort (6) sont agencés de manière telle l'un sur l'autre et dans le boîtier que la plaque de support (2), le support de ressort (3) et le compresseur de ressort (6) sont pressés l'un contre l'autre et contre le boîtier (1) au moyen de l'au moins un ressort en plastique (4).

2. Appareil électronique selon la revendication 1, **caractérisé en ce qu'**un connecteur (8) est relié à la plaque de support (2) par des éléments de contact coudés (9).

3. Appareil électronique selon la revendication 1, **caractérisé en ce qu'**un élément de contact à la masse (14) comprenant une languette (10), une broche de contact (11) et une étanchéité de conducteur individuel (12), entrant dans le boîtier (1) par un perçage (13), est agencé de telle sorte que la broche de contact (11) entre en contact avec un ressort de contact (16) agencé sur la surface d'équipement (15) de la plaque de support (2).

4. Appareil électronique selon la revendication 3, **caractérisé en ce qu'**une console de montage (17) agencée sur le boîtier (1) présente, sur une face inférieure, un creux (18) ayant la forme de la languette (10) de l'élément de contact à la masse (14), dans lequel est agencée la languette (10).

5. Appareil électronique selon la revendication 4, **caractérisé en ce que** l'élément de contact à la masse (14) est maté avec la console de montage (17) par la languette (10) sur laquelle sont agencées des dents de montage (19) le long d'une trajectoire circulaire.

6. Procédé de montage d'un appareil électronique selon l'une des revendications 1, 2, 3, 4 ou 5, **caractérisé en ce que** :
le compresseur de ressort (6) est agencé sur le support de ressort (3) de telle sorte qu'il y a une adaptation entre le profil en dents de scie (5) du support de ressort (3) et le contre-profil en dents de scie (7) du compresseur de ressort,
la plaque de support (2) est introduite dans le boitier (1) parallèlement à une face latérale du boîtier (1) via une ouverture du boîtier (1) jusqu'à contact entre la plaque de support (2) et une paroi arrière du boîtier,
le support de ressort (3) avec le compresseur de ressort (6) agencé dessus est introduit dans le boîtier (1) parallèlement à une face latérale du boîtier via une ouverture du boîtier jusqu'à contact entre le support de ressort (3) et une paroi arrière du boîtier et
le compresseur de ressort (6) est enfoncé plus avant dans le boîtier (1) parallèlement à une face latérale du boîtier (1) jusqu'à contact entre le compresseur de ressort (6) et une paroi arrière du boîtier.
